# EUROPÄISCHE PATENTSCHRIFT

(11) **EP 0 527 477 B1**
(45) Veröffentlichungstag und Bekanntmachung des Hinweises auf die Patenterteilung: **17.01.1996**
(21) Anmeldenummer: 92113720.4
(22) Anmeldetag: 12.08.1992
(51) Int. Cl.: C30B 15/30

(54) **Verfahren zur Regelung des Sauerstoffgehaltes in Siliciumkristallen**
Process for controlling the oxygen content in silicon crystals
Procédé pour contrôler la teneur en oxygène des cristaux de silicium

(30) Priorität: 14.08.1991 US 744891
(43) Veröffentlichungstag der Anmeldung: 17.02.1993
(73) Patentinhaber: MEMC Electronic Materials, Inc., St. Peters, Missouri 63376 (US)
(72) Erfinder: Frederick, Roger Allen, St. Peters, Missouri 63376 (US)
(74) Vertreter: Maiwald, Walter, Dr. Dipl.-Chem.

(56) Entgegenhaltungen:
- EP-A- 0 042 901
- EP-A- 0 055 619
- WO-A-89/08731
- US-A- 4 659 423
- JOURNAL OF CRYSTAL GROWTH, Bd. 104, Nr. 3, August 1990, AMSTERDAM, NL, Seiten 617-628; RAVISHANKAR: "Impurities in commercial scale magnetic czochralski silicon:axial versus tranverse magnetic fields"

## Beschreibung

### HINTERGRUND DER ERFINDUNG

Die Erfindung bezieht sich auf ein Czochralski-Verfahren zur Herstellung von Einkristallsiliciumstäben mit Hilfe einer Kombination aus variiertem, scheitelförmig ausgebildetem Magnetfeld, variierter Kristallgröβe und variierten Tiegeldrehgeschwindigkeiten.

Wenn ein Kristall aus einer geschmolzenen Flüssigkeit in einem Behälter gezüchtet wird, werden die Bestandteile des Behälters teilweise in der geschmolzenen Flüssigkeit aufgelöst, wobei sie als Verunreinigungen in den Kristall hineinwandern. Bei der Siliciumschmelztemperatur (ca. 1420 °C) löst sich die Oberfläche des Siliciumdioxid-(SiO₂)-Tiegels, die mit der Schmelze in Berührung kommt, auf. Ein Teil des aufgelösten Siliciumdioxids verdampft als SiO (Siliciummonoxid) von der Schmelzenoberfläche. Ein weiterer Teil des aufgelösten Siliciumdioxids wird in den wachsenden Kristall integriert. Das restliche aufgelöste Siliciumdioxid verbleibt im geschmolzenen Silicium. Somit stellt der Siliciumdioxidtiegel, der zur Aufnahme der Siliciumschmelze dient, die Quelle des Sauerstoffs dar, der in den nach der herkömmlichen Czochralski-Technik gezogenen Siliciumkristallen vorhanden ist.

Sauerstoff in Siliciumkristallen kann sowohl günstige als auch unvorteilhafte Wirkungen hervorrufen. Bei den diversen Wärmebe handlungsvorgängen bei der Herstellung der verschiedenen elektrischen Geräte kann der Sauerstoff im Kristall Kristallbaufehler wie Ausfällungen, Versetzungs- und Stapelfehler verursachen oder elektrisch aktive Fehler bewirken, die zu Geräten mit verschlechterten Leistungskennlinien führen. Die feste Lösung von Sauerstoff im Kristall erhöht jedoch die mechanische Festigkeit der Siliciumscheiben und die Kristallbaufehler können den Bildungsgrad an konformen Produkten durch Einschluß von Schwermetallverunreinigungen verbessern. Demgemäß stellt der Sauerstoffgehalt von Siliciumkristallen einen wichtigen Faktor für die Produktqualität dar, der sorgfältig im Hinblick auf die Anforderungen für die letztendliche Anwendung der Siliciumscheiben gesteuert werden muß.

Die Sauerstoffkonzentration in Siliciumkristallen, die unter Czochralski-Bedingungen, die in der Industrie Anfang der 80er Jahre vorherrschten, gewachsen sind, variierte entlang der Kristallänge; z.B. war sie am Keimende höher als in der Mitte und/oder unten oder am spitzen Ende des Kristalls. Außerdem variierte die Sauerstoffkonzentration entlang des Radius einer Kristallquerschnittsscheibe.

Frederick et al. stellten im US-Patent Nr. 4,436,577 ein Verfahren zur Regulierung des Sauerstoffgehalts und der Verteilung des Sauerstoffgehalts in Siliciumkristallstäben vor, die durch das Vorlegen eines Impfkristalls in einer Siliciumschmelze gezogen wurden, die sich in einem Siliciumdioxidtiegel befand. Nach dieser Methode wird die Sauerstoffverteilung durch Rotation des aus der Schmelze gezogenen Kristallkeimstabs bei einer höheren Rotationsgeschwindigkeit und in entgegengesetzter Richtung zur Schmelztiegelrotation gesteuert, wobei die Tiegelrotationsgeschwindigkeit mit abnehmendem Schmelzfüllstand erhöht wird.

Die Fortschritte in der Siliciumhalbleitertechnologie der letzten Jahre haben jedoch, im Vergleich zu den im Patent von Frederick et al. dargestellten, zu größeren Durchmessern der Siliciumkristalle geführt. Folglich sind höhere Schmelzchargengewichte und größere Tiegeldurchmesser erforderlich. Außerdem hat sich die Halbleiterfertigungstechnologie dahingehend entwickelt, allgemein geringere und präziser gesteuerte Sauerstoffgehalte in Siliciumscheiben, die aus den Stäben geschnitten werden, zu fordern. Dementsprechend ist es zunehmend schwieriger geworden, den Sauerstoffgehalt in allen gewünschten Konzentrationsstufen zu homogenisieren, und zwar aufgrund der physikalischen Beschränkungen, die durch die größeren physikalischen Parameter auferlegt werden, die wiederum den Bereich der Kristall- und Tiegelrotationsgeschwindigkeiten, bei denen ein stabiles Kristallwachstum möglich ist, einschränken.

Als Lösung dieses zunehmend schwierigen Sauerstoffregelungsproblems ist in den letzten Jahren dem Einsatz eines axial-symmetrischen und radialen, scheitelförmig ausgebildeten Magnetfeldes Aufmerksamkeit geschenkt worden. Dieses Verfahren wurde im japanischen Kokai-Patent Nr. Sho 58[1983]-217493 vorgeschlagen. Nach dieser Methode wird ein Spulenpaar, durch das kreisförmige Ströme in entgegengesetzten Richtungen fließen, über und unter der geschmolzenen Flüssigkeit angeordnet. Das ergibt ein radial-horizontales Magnetfeld auf halber Position entlang der Tiefe der geschmolzenen Flüssigkeit. Dem Anmelder zufolge schränkt das radiale, scheitelförmig ausgebildete Magnetfeld den Fluß der geschmolzenen Flüssigkeit ein, wobei die Schmelze stabilisiert und die Verunreinigung durch den Tiegel verhindert wird.

Barraclough et al. haben in WO 89/08731 (21.09.89) eine Verbesserung der Methode mit scheitelförmig ausgebildetem Magnetfeld vorgestellt. Nach Barraclough et al. sollte das Magnetfeld eine Feldkomponente parallel zur Kristallrotationsachse haben, die weniger als 500 Gauß an der Schnittstelle zwischen dem wachsenden Kristall und der Schmelze beträgt und an anderen Stellen der Schmelze einen Wert über 500 Gauß hat, und diese Magnetfeldverteilung während des Kristallwachstums beibehalten.

Hirata et al. haben eine andere Verbesserung im japanischen Kokai-Patent Nr. Hei 1[1989]-282185 vorgeschlagen. Nach Hirata et al. werden eindringende Verunreinigungen wie Sauerstoff durch ein der Schmelze aufgeprägtes scheitelförmig ausgebildetes Magnetfeld gesteuert, wobei Tiegel und Kristall in entgegengesetzten Richtungen drehen und der Tiegel schneller als der Kristall dreht.

Im japanischen Kokai-Patent Nr. Hei 2[1990]-55284 haben Hirata et al. noch eine weitere Verbesserung vorgeschlagen. Nach Hirata et al. werden eindringende Verunreinigungen wie Sauerstoff durch ein der Schmelze aufgeprägtes scheitelförmig ausgebildetes Magnetfeld gesteuert, wobei das Verhältnis der Intensität der Magnetfeldkomponente, die die Oberfläche der geschmolzenen Flüssigkeit rechtwinklig durchdringt, zur Intensität der Magnetfeldkomponente, die die untere Oberfläche der geschmolzenen Flüssigkeit rechtwinklig durchdringt, variiert wird. Dieses Verhältnis kann geändert werden durch: (1) Bewegen der Spulen relativ zum Tiegel (wobei der Abstand zwischen den Spulen konstant bleibt), (2) Ändern des Amperewindungsverhältnisses zwischen den Spulen oder (3) Ändern des Abstands zwischen den Spulen.

Keine der bisher vorgestellten Methoden mit scheitelförmig ausgebildetem Magnetfeld war jedoch völlig zufriedenstellend. Unter bestimmten Bedingungen weisen Kristalle, die in scheitelförmig ausgebildeten Magnetfeldern gewachsen sind, eine ungleichmäßige axiale und radiale Sauerstoffverteilung auf, die der bei axialen Feldern beobachteten ähnlich ist. Das Problem tritt überwiegend in den letzten Stufen des Verfestigungsprozesses auf, möglicherweise als Folge einer Ansammlung von Sauerstoff oder sauerstoffhaltigen Verbindungen in einer Stagnationszone nahe dem relativ starken, vertikal gerichteten Magnetfeld in diesem Bereich.

### INHALT DER ERFINDUNG

Zu den Zielen der vorliegenden Erfindung zählen daher die Bereitstellung einer Methode zur Regulierung des Sauerstoffgehalts und der Verteilung des Sauerstoffgehalts in Siliciumkristallstäben, die durch das Vorlegen eines Impfkristalls in einer Siliciumschmelze gezogen werden, die sich in einem Siliciumdioxidtiegel befindet, die Bereitstellung eines Prozesses, der eine gleichmäßige Verteilung des Sauerstoffgehalts sowie das gewünschte Niveau des Sauerstoffgehalts realisiert, sowie die Bereitstellung eines Prozesses, der sich für die Herstellung der Siliciumstäbe eignet, die einen relativ großen Durchmesser und einen relativ niedrigen Sauerstoffgehalt aufweisen.

Kurz ausgedrückt: Aus diesen Gründen richtet sich die vorliegende Erfindung auf das Czochralski-Verfahren zur Herstellung von Siliciumstäben, wobei ein Einkristallstab aus einer Siliciumschmelze gezogen wird, die sich in einem Tiegel koaxial zum Stab befindet. Bei diesem Verfahren rotieren Stab und Tiegel in entgegengesetzten Richtungen um ihre Achsen, wobei die Rotationsgeschwindigkeit des Stabs beim Wachstum höher ist als die des Tiegels. Die Rotationsgeschwindigkeit des Tiegels wird mit zunehmender Stablänge erhöht. Ein im wesentlichen um die Stabachse rotationssymmetrisches Magnetfeld wird der Siliciumschmelze aufgeprägt, bis ein Teil der Siliciumschmelze verfestigt ist, wobei das Magnetfeld Komponenten besitzt, die den Boden und die Seitenwände des Tiegels rechtwinklig durchdringen. Mit zunehmendem Anteil verfestigter Siliciumschmelze nimmt die Intensität der Magnetfeldkomponente, die den Tiegelboden und die -seitenwände durchdringt, ab.

### KURZBESCHREIBUNG DER ZEICHNUNGEN

- Fig. 1: zeigt einen Schnitt durch einen CzochralskiKristallwachstumsapparat unter Berücksichtigung der vorliegenden Erfindung;
- Fig. 2: zeigt einen vergrößerten Ausschnitt der Fig. 1 sowie ein Magnetfeld, das unter einer Gruppe von Bedingungen (1500 A), die im Beispiel aufgeführt werden, erzeugt wird;
- Fig. 3: zeigt ein lineares Modell für die Sauerstoffkonzentration eines 150-mm-Siliciumkristallstabs, der wie im Beispiel ausgeführt gezogen wurde;
- Fig. 4-9: zeigen die Kombination aus Feldstrom und Tiegelrotationsgeschwindigkeit. Das Modell der Beispielvorgaben führt zu vier verschiedenen Sauerstoffniveaus für 6 unterschiedliche Längen eines 150-mm-Siliciumkristalls.
- Fig. 10: zeigt eine Programmkombination aus Feldstärke und Tiegelrotationsgeschwindigkeit. Das Modell der Beispielvorgaben führt zu einem Sauerstoffgehalt von 13 ppma für einen 150-mm-Siliciumeinkristall.

### DETAILLIERTE BESCHREIBUNG DER BEVORZUGTEN AUSFÜHRUNG

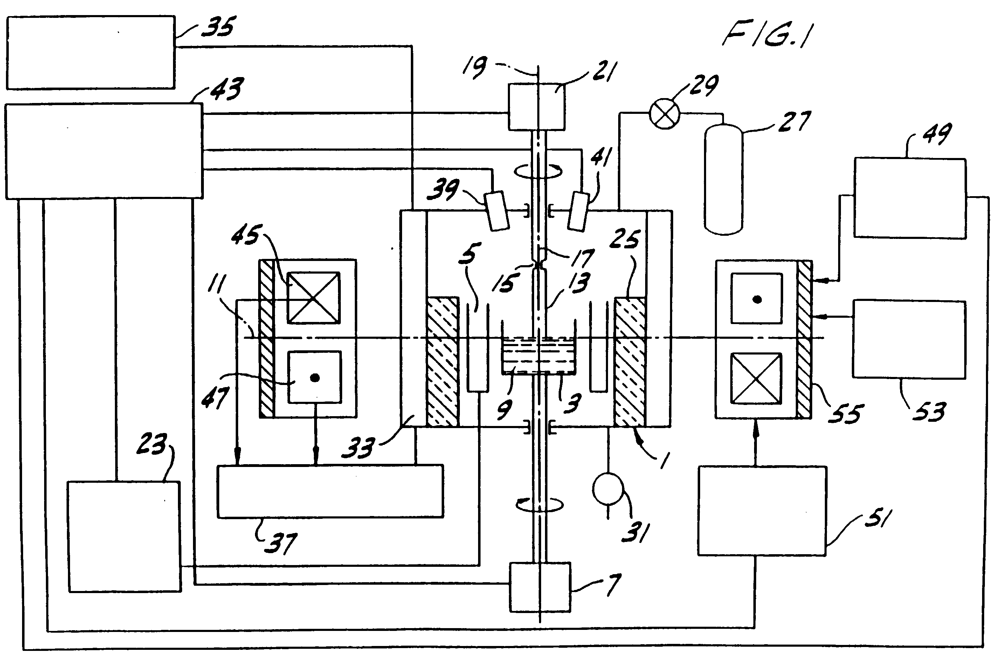

In Fig. 1 ist ein Czochralski-Kristallziehapparat für den Einsatz gemäß der vorliegenden Erfindung dargestellt. In der Vakuumkammer 1 befindet sich der Schmelztiegel 3, umgeben von einem Widerstandsheizer 5. Die Tiegelantriebseinheit 7 dreht den Tiegel im Uhrzeigersinn, wie durch den Pfeil angezeigt wird, und hebt und senkt den Tiegel nach Bedarf. Der Tiegel 3 enthält Siliciumschmelze mit einem Schmelzniveau 11, aus dem ein Einkristall 13 gezogen wird, wobei mit dem Impfkristall 15 begonnen wird, der am Ziehschaft oder Kabel 17 befestigt ist. Tiegel 3 und Einkristall 13 haben eine gemeinsame Symmetrieachse 19. Der Ziehschaft oder das Kabel 17 werden entgegen dem Uhrzeigersinn gedreht und von der Kristallantriebseinheit 21 nach Bedarf angehoben oder gesenkt. Die Heizstromversorgung 23 speist den Widerstandsheizer 5, und die Isolierung 25 kleidet die Innenwand der Vakuumkammer aus. Argongas wird aus einer Flasche 27 über einen Gasdurchflußregler 29 in die Vakuumkammer 1 in dem Maße gespeist, wie das Gas mittels der Vakuumpumpe 31 aus der Vakuumkammer gesaugt wird. Die Vakuumkammer ist von einem Kühlmantel 33 umgeben, der mit Kühlwasser aus einem Vorratsbehälter 35 versorgt wird. Das Kühlwasser fließt dann zum Kühlwasserrücklaufsammler 37 ab. Eine Fotozelle 39 mißt die Schmelzenoberflächentemperatur, und der Durchmessermeßumformer 41 mißt den Durchmesser des Einkristalls 13. Ihre Signale werden von der Steuereinheit 43 verarbeitet. Diese Steuereinheit kann ein programmierter Digital- oder Analogrechner sein; er steuert die Tiegelund Einkristallantriebseinheiten 7 und 21, die Heizstromversorgung 23, obere und untere Spulenstromversorgung 49 und 51, die Pumpe 31 und den Argondurchflußregler 29.

Außerhalb der Vakuumkammer 1 sind die obere Magnetspule 45 und die untere Magnetspule 47 achsensymmetrisch über und unter der Siliciumschmelzenoberfläche 11 angeordnet. Die obere und untere Spule verfügen jeweils über eine eigene Stromversorgung: obere Spulenstromversorgung 49 und untere Spulenstromversorgung 51, die beide mit der Steuereinheit 43 verbunden sind. Zur Erzeugung des scheitelförmig ausgebildeten Magnetfeldes fließt der Strom in den beiden Magneten in entgegengesetzten Richtungen. Der Vorratsbehälter 53 versorgt die obere und untere Spule mit Kühlwasser, das dann in den Kühlwasserrücklaufsammler 37 abfließt. Ein Eisenschirm 55 umgibt die obere und untere Spule, um magnetische Streufelder zu verringern und die Stärke des erzeugten Feldes zu vergrößern.

Für das Wachstum eines Siliciumeinkristalls wird polykristallines Silicium in den Tiegel 3 gegeben und elektrischer Strom durch den Heizer 5 geführt, um die Charge zu schmelzen. Die Siliciumschmelze kann auch bestimmte Dotiermittel enthalten, die zur Änderung der elektrischen Kennlinien des Siliciums gemäß bekannter Technik eingebracht werden. In einer Schutzgasatmosphäre wie Argon wird ein Impfkristall 15 abgesenkt, um mit der Schmelze in Berührung zu kommen und dann langsam von der Schmelze zurückgezogen; das Silicium verfestigt sich auf dem Keim und bewirkt so das Wachstum eines Einkristalls. Ein zylindrischer Einkristallstab 13 wird erzielt, indem der Kristall während des Ziehens mit einer vorgegebenen Geschwindigkeit gedreht wird. Der Tiegel wird ebenfalls mit einer zweiten vorgegebenen Geschwindigkeit gedreht, jedoch in entgegengesetzter Richtung wie der Stab. Die Rückzugsgeschwindigkeit und der Heizstrom werden anfänglich so gesteuert, daß ein Hals am Kristall entsteht. Anschließend wird eine Einstellung vorgenommen, die den Kristalldurchmesser kegelförmig erweitert, bis der vorgegebene Durchmesser erreicht ist. Rückzugsgeschwindigkeit und Heizung werden dann so gesteuert, daß der Durchmesser bis fast zum Ende des Vorgangs konstant gehalten wird. Zu diesem Zeitpunkt werden die Rückzugsgeschwindigkeit und die Heizung erhöht, so daß der Durchmesser abnimmt und eine kegelförmige Spitze am Ende des Einkristallstabs gebildet wird.

Nachdem der Einkristall 13 den vorgegebenen Durchmesser (z.B. 150 mm oder 200 mm) erreicht hat, werden die Rotationsgeschwindigkeiten des Einkristalls und des Tiegels so gesteuert, daß die Konzentration und die Verteilung des darin enthaltenen Sauerstoffs sowohl axial als auch radial reguliert werden. Typischerweise liegt die Rotationsgeschwindigkeit des Tiegels zwischen 1 und 10 U/min, vorzugsweise mindestens bei ca. 4 U/min, und die Rotationsgeschwindigkeit des Einkristalls liegt beträchtlich höher als die des Tiegels. Außerdem werden zur Vermeidung von Wellenbildung im geschmolzenen Silicium die Tiegelund Einkristallrotationsgeschwindigkeiten so gesteuert, daß ihre Summe den vorgegebenen Wert nicht überschreitet. Der vorgegebene Wert wird für jedes System empirisch ermittelt und hängt vom Einkristalldurchmesser, dem Tiegeldurchmesser und der Siliciummenge ab, die in den Tiegel gefüllt wird. Beispielsweise sollte die Summe der Tiegel- und Kristallrotationsgeschwindigkeiten 32 (25) U/min bei einem 150-mm-(200-mm)-Stab, einem 350-mm(450 mm)-Tiegel und einer 34-kg-(60kg-)Siliciumcharge nicht überschreiten.

Es ist bereits festgestellt worden, daß die Sauerstoffmenge in Einkristallen nicht allein von der Tiegelfläche, die mit der Schmelze in Berührung kommt, abhängt, sondern auch von der Tiegelrotationsgeschwindigkeit (siehe US-Patent Nr. 4,436,577, auf das in dieser Unterlage Bezug genommen wird). Im allgemeinen nimmt der Sauerstoffgehalt in der Säule in axialer Richtung mit zunehmendem Anteil verfestigter Schmelze bei vorgegebenen Säulen- und Tiegelrotationsgeschwindigkeiten ab. Dementsprechend kann diesem Effekt zumindest teilweise begegnet werden, indem die Tiegelrotationsgeschwindigkeit mit zunehmendem verfestigten Anteil erhöht wird. Bezeichnenderweise ist es jedoch zunehmend schwierig geworden, allein durch die Steuerung der Rotationsgeschwindigkeiten den Sauerstoffgehalt in Einkristallstäben zu regulieren, die relativ große Durchmesser und relativ niedrige Sauerstoffkonzentrationen aufweisen, wie z.B. weniger als 15 ppma (ASTM-Norm F-121-83).

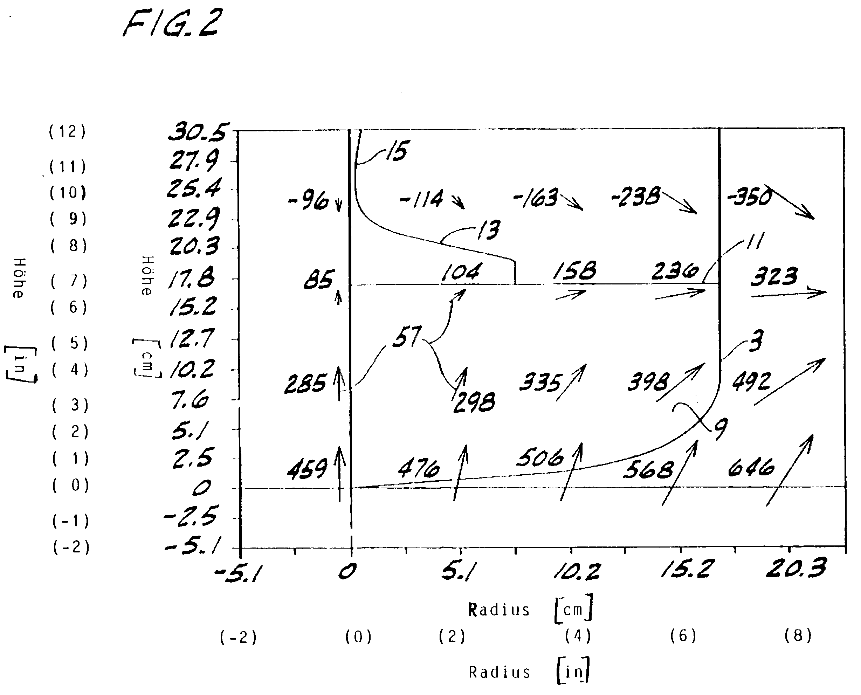

Es ist festgestellt worden, daß die Sauerstoffkonzentration in axialer und radialer Richtung bei Einkristallstäben mit relativ großem Durchmesser und besonders niedrigen Sauerstoffkonzentrationen präziser regulierbar ist, wenn die Rotationsgeschwindigkeiten gesteuert und ein radiales, scheitelförmig ausgebildetes Magnetfeld gemäß dem beschriebenen Programm der Siliciumschmelze aufgeprägt werden. Mit Bezug auf die Fig. 1 und 2 werden nun ein Programm und ein entsprechender Apparat beschrieben. Durch die obere und untere Spule 45, 47 dringt Strom wie angezeigt ("·" zeigt den Stromfluß aus der Seite heraus und "x" den Stromfluß in die Seite hinein an), wobei dem Tiegel 3 und der Siliciumschmelze 9 ein Magnetfeld aufgeprägt werden. Die Form des Feldes wird durch Vektoren 57 gekennzeichnet, die in der Gauß-Einheit, wie dargestellt, angegeben werden. Das Feld hat horizontale und vertikale Komponenten, die den Boden und die Seitenwände des Tiegels rechtwinklig durchdringen. Zudem kann das Feld eine vertikale Komponente besitzen, die die Siliciumschmelzenoberfläche rechtwinklig durchdringt. Die durchschnittliche Magnetfeldkomponente, die die geschmolzene Siliciumoberfläche rechtwinklig durchdringt, ist vorzugsweise klein in Bezug auf die durchschnittliche Magnetfeldkomponente, die den Boden und die Seitenwände des Tiegels, die mit dem geschmolzenen Silicium in Berührung kommen, rechtwinklig durchdringt, d.h. die durchschnittliche Magnetfeldkomponente, die die geschmolzene Siliciumoberfläche rechtwinklig durchdringt, ist nicht größer als ca. ein Zehntel der durchschnittlichen Magnetfeldkomponente, die rechtwinklig den Boden und die Seitenwände des Tiegels durchdringt, die mit dem geschmolzenen Silicium in Berührung kommen. Im Idealfall liegt die durchschnittliche Magnetfeldkomponente, die die geschmolzene Siliciumoberfläche rechtwinklig durchdringt, bei oder nahe Null, d.h. die Magnetfeldnullebene befindet sich an oder nahe der Siliciumschmelzenoberfläche. Die vertikale Position, die Anzahl der Windungen und der relative Strom in den beiden Spulen 45, 47 können zur Positionierung des Nullmagnetfeldes an oder nahe der Ebene der Schmelzenoberfläche 11 herangezogen werden.

Bei Einleitung des Kristallziehvorgangs dringt Strom durch die Spulen 45, 47, um der Siliciumschmelze und dem Tiegel ein Magnetfeld mit vorgegebener Intensität aufzuprägen. Die vorgegebene Intensität richtet sich nach dem Säulendurchmesser, dem Tiegeldurchmesser, der Chargenmenge und dem gewünschten Sauerstoffgehalt, kann jedoch schnell ohne übermäßiges Experimentieren ermittelt werden. Im allgemeinen liegt die vorgegebene Magnetfeldhöchstintensität unter einigen tausend Gauß, im Idealfall zwischen 400 und 1000 Gauß. Mit zunehmender Länge des Einkristalls, d.h. mit zunehmendem Anteil verfestigter Schmelze, wird die Feldintensität gesenkt, und zwar durch Verringern der Strommenge, die durch die Spulen fließt, durch die Bewegung der Spulen proportional zum Tiegel oder durch Bewegen oder Eliminieren des Magnetschirms. Vorzugsweise wird die Intensität durch Verringern der Strommenge gesenkt, die durch die Spulen fließt.

Mit abnehmender Magnetfeldintensität nehmen auch die Magnetfeldkomponenten, die den Boden und die Seitenwände des Tiegels rechtwinklig durchdringen, ab. Da jedoch die Nullebene des Magnetfeldes an oder nahe der Siliciumschmelzenoberfläche aufrechterhalten wird, ändert sich das Verhältnis der durchschnittlichen Magnetfeldkomponente, die die Siliciumschmelzenoberfläche rechtwinklig durchdringt, zur durchschnittlichen Magnetfeldkomponente, die den Boden und die Seitenwände des Tiegels, die mit dem geschmolzenen Silicium in Berührung kommen, rechtwinklig durchdringt, nur geringfügig.

Obwohl die Magnetfeldintensität auf einen Wert unterhalb ihres anfänglichen Niveaus eingestellt werden kann, wenn die Länge des Einkristallstabs und der Anteil der verfestigten Schmelze zunehmen, wird es vorgezogen, das Magnetfeld vollständig auszuschalten, nachdem ein vorgegebener Anteil der Schmelze erstarrt ist. Typischerweise wird das Magnetfeld abgeschaltet, nachdem ca. 50 % bis 80 % der Schmelze erstarrt sind. Anschließend wird der Sauerstoffgehalt durch Erhöhen der Tiegelrotationsgeschwindigkeit proportional zur Einkristallrotationsgeschwindigkeit reguliert.

In Abhängigkeit solcher Parameter wie Einkristallnenndurchmesser, Tiegeldurchmesser, Chargengröße und Magnetfeldkennlinien kann es wünschenswert sein, die Stärke des Magnetfeldes, das der Schmelze aufgeprägt worden ist, zu verringern und/oder die Tiegelrotationsgeschwindigkeit an einem Punkt des Vorgangs zu erhöhen. Solche Ausführungsformen werden im Rahmen der vorliegenden Erfindung in Betracht gezogen, soweit (a) das Magnetfeld auf einen Wert unterhalb seines anfänglichen Niveaus gesenkt wird und (b) die Tiegelrotationsgeschwindigkeit proportional zur Einkristallgeschwindigkeit nach Verfestigung eines Teils der Schmelze erhöht wird.

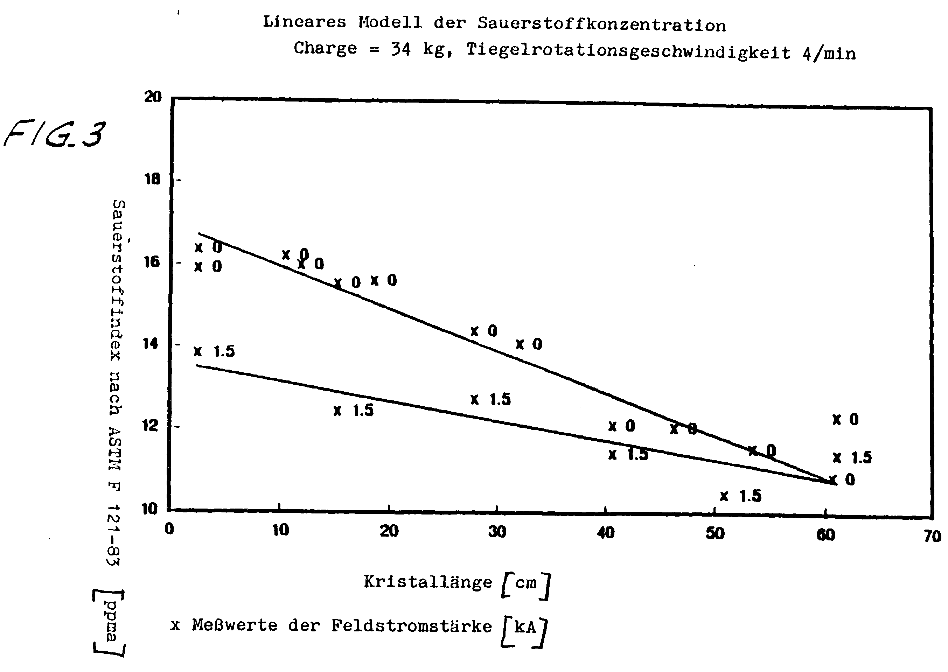

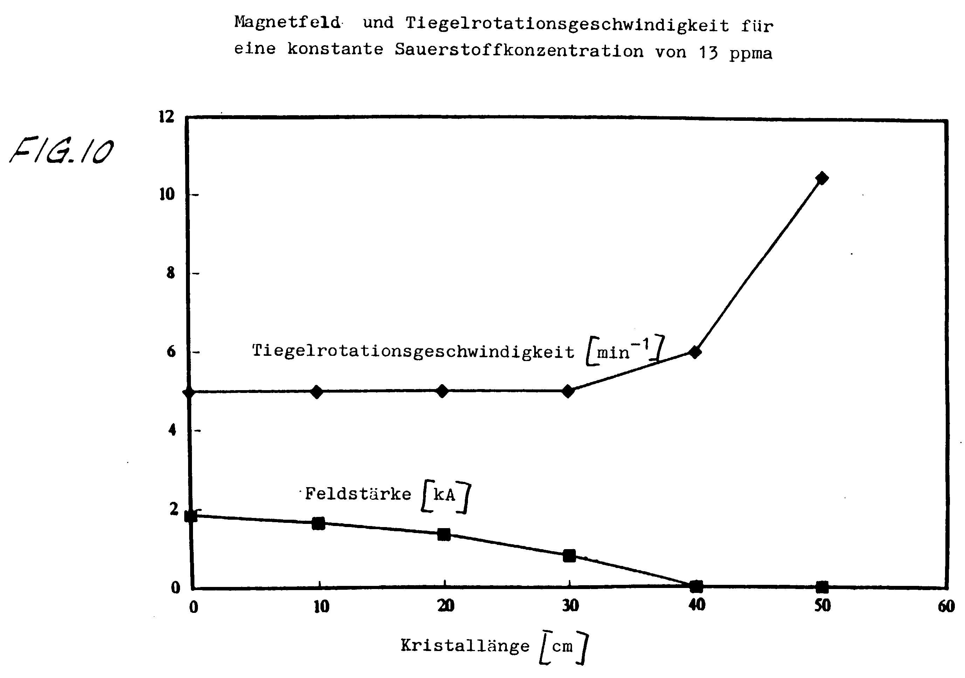

Wie im folgenden Beispiel gezeigt, kann das Verfahren gemäß der vorliegenden Erfindung zur präzisen Regelung der Sauerstoffkonzentration in Einkristallen mit relativ niedriger Sauerstoffkonzentration, d.h. unter 15 ppma Sauerstoff, eingesetzt werden. Der Sauerstoffgradient dieser Einkristallstäbe liegt vorzugsweise unter 5 % in radialer Richtung und unter 5 % bis 10 %, idealerweise 5 %, in axialer Richtung. Im Beispiel ist eine Gruppe von Bedingungen beschrieben, die zur Erzielung des gewünschten Ergebnisses eingesetzt werden können. Ähnliche Werte wie in Fig. 3 können auch für andere Kristalldurchmesser, Feldstärken, Tiegelrotationsgeschwindigkeiten, Tiegelgrößen und Siliciumchargen erreicht werden. Wie in Fig. 10 gezeigt, können dann eine Tiegelrotationsgeschwindigkeit und ein Feldstärkenerhöhungsprogramm zur Erzielung der gewünschten Sauerstoffverteilung abgeleitet werden.

Das nachstehende Beispiel veranschaulicht die Erfindung.

### BEISPIEL

Es wurden Einkristallstäbe (150 mm Nenndurchmesser) aus einem Tiegel mit einem Durchmesser von 350 mm, der eine polykristalline Siliciumcharge von 34 kg enthielt, unter Verwendung des in Fig. 1 und 2 dargestellten Apparates (die Spulen waren jedoch in Reihe geschaltet und wurden von nur einer Stromquelle versorgt) gezogen. Die Rotationsgeschwindigkeit des Kristalls lag zwischen 12 und 24 U/min und die Tiegelrotationsgeschwindigkeit betrug 4 U/min. Bei einer Versuchsreihe wurde kein Magnetfeld aufgeprägt. In einer anderen Versuchsreihe wurde ein Feld, das sich aus 1,5 Kiloampere ergab, die durch jede Spule in entgegengesetzten Richtungen geleitet wurden, mit einer durchschnittlichen Feldintensität an der Silicium/Quarz-Schnittstelle von ca. 400 Gauß, wie in Fig. 2 gezeigt, aufgeprägt. In anderen Versuchsreihen wurden Tiegelrotationsgeschwindigkeit und Feldstärke variiert.

Die axiale Sauerstoffverteilung in den Einkristallstäben wurde ermittelt, und die sich ergebenden Sauerstoffwerte wurden an ein Modell angepaßt, wobei der Sauerstoff die abhängige Variable war. Die unabhängigen Variablen waren Kristallänge, Magnetfeld (als Spulenerregerstrom ausgedrückt) und Tiegelrotationsgeschwindigkeit. Das lineare Modell hat 6 Koeffizienten, die nachstehend aufgeführt werden:

| NR. KOEFFIZIENT VARIABLE - LINEAR KOEFFIZIENTENEINHEITEN | | | |
|---|---|---|---|
| 1 | 15,573 | KONSTANT | ppma (ASTM F121-83) |
| 2 | -0,118 | LÄNGE | ppma/cm |
| 3 | 0,286 | TIEGELROTATION | ppma/U/min |
| 4 | -2,153 | FELDSTÄRKE | ppma/Kiloampere |
| 5 | 0,063 | LÄNGE/TIEGEL ROT. | ppma x U/min/cm |
| 6 | 0,037 | LÄNGE x FELD | ppma/cm/Kiloampere |

Alle Koeffizienten sind bis zu 0,0001 oder weniger signifikant, und der Fehler des quadratischen Mittels beträgt 0,44 ppma. Fig. 3 zeigt die Modellanpassung an die Versuchsreihen.

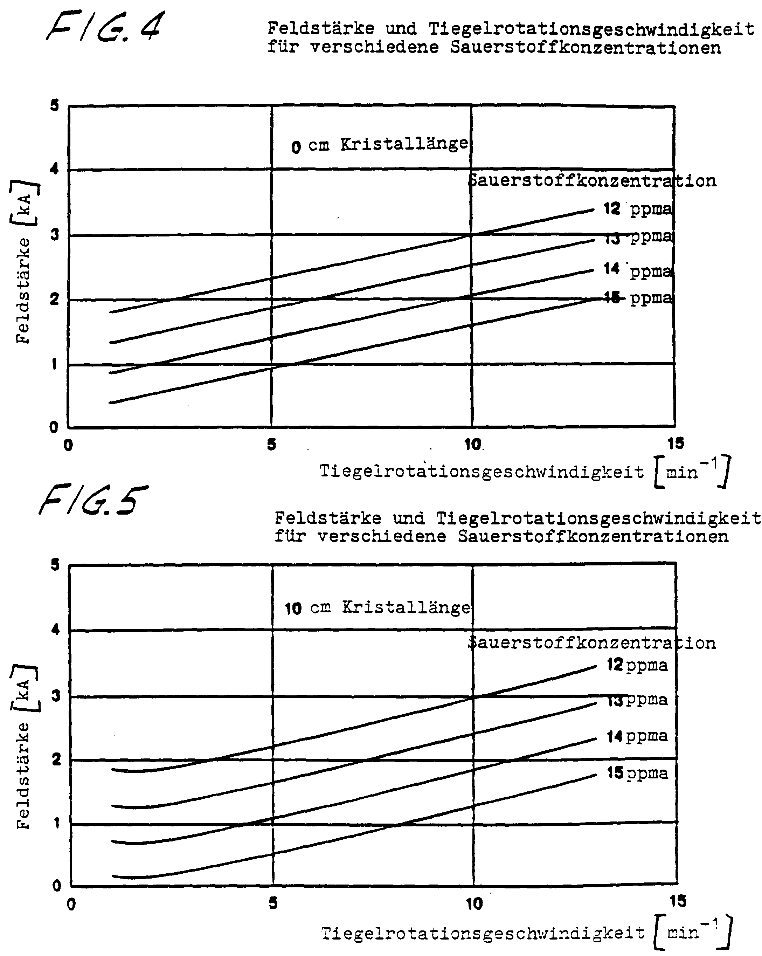

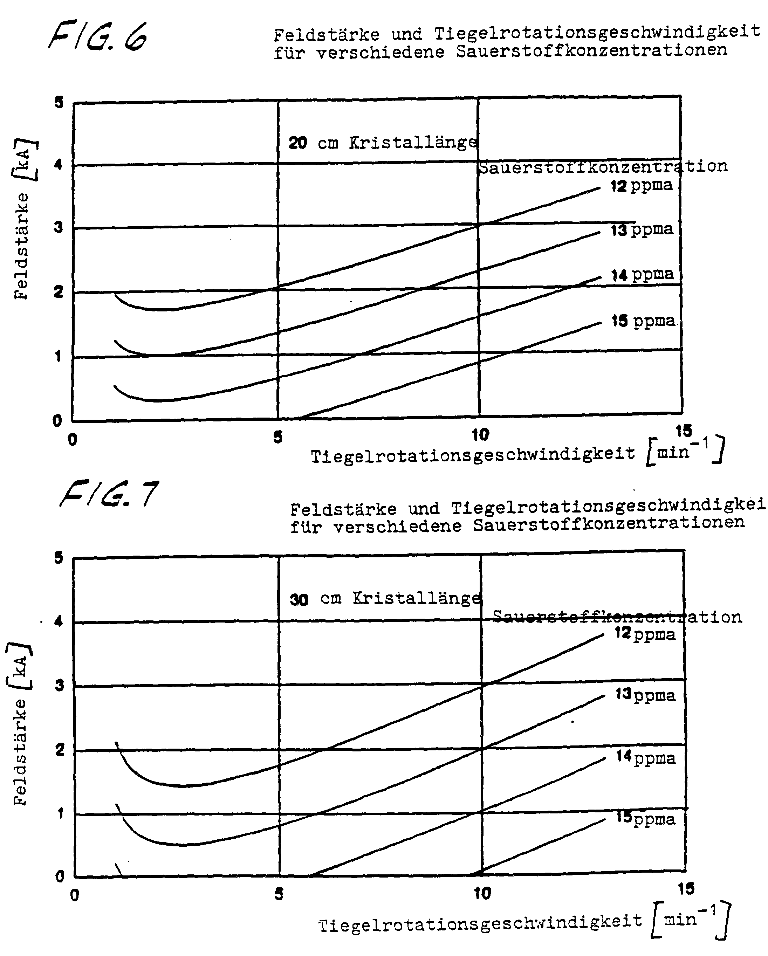

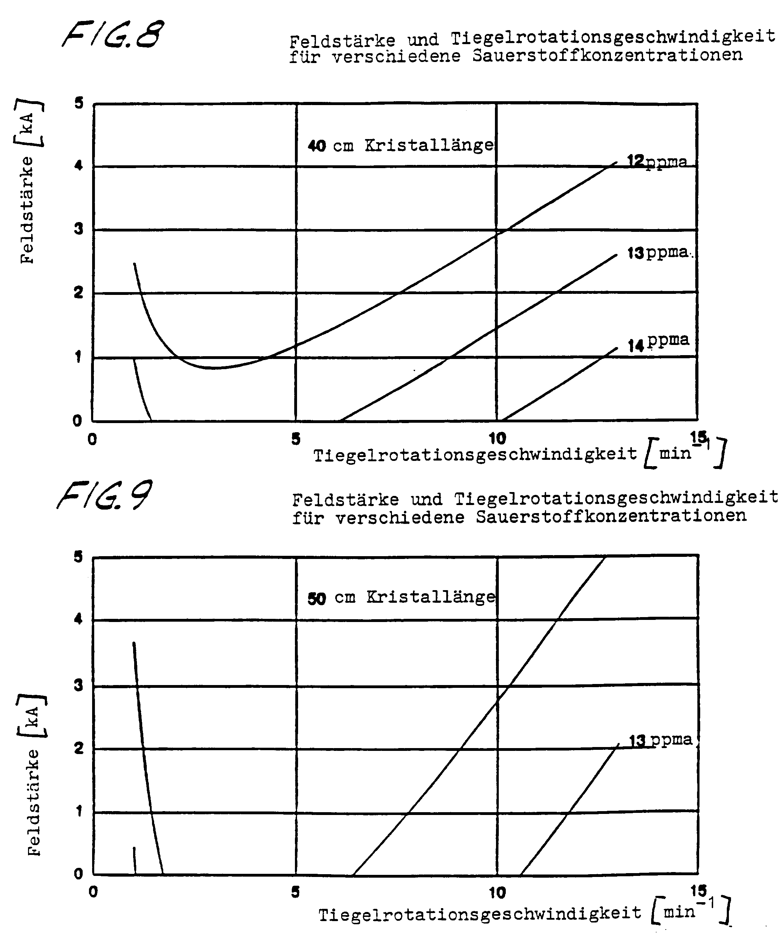

- Fig. 4-9: zeigen die Kombination von Feldstrom und Tiegelrotationsgeschwindigkeit. Die Modellvorgaben führen zu vier verschiedenen Sauerstoffniveaus für 6 unterschiedliche Kristallängen. Sofern nicht anders angegeben, wurden alle Sauerstoffwerte gemäß der ASTM-Norm F121-83 und die Länge in Zentimetern gemessen.
- Fig. 10: zeigt eine Programmkombination von Feldstärke und Tiegelrotationsgeschwindigkeit. Die Modellvorgaben führen zu einem Sauerstoffgehalt von 13 ppma. Nach diesem Programm wird zu Anfang die Tiegelrotationsgeschwindigkeit auf 5 U/min eingestellt und ein Feld aufgeprägt, das sich aus ca. 2 Kiloampere ergibt, die durch jede Spule in entgegengesetzten Richtungen geleitet werden. Nachdem jeweils 10, 20, 30 und 40 cm des Kristalls gezogen worden sind, wird die Feldstärke wie angegeben verringert; bei 40 cm Kristallänge wird die Feldstärke auf Null gesenkt. Mit der Verminderung der Feldstärke wird die Tiegelrotationsgeschwindigkeit von 5 auf 6 U/min bei Erreichen von 40 cm erhöht und bei Erreichen von 50 cm auf 10 U/min.

Ähnliche Werte wie in Fig. 10 können auch für andere Kristalldurchmesser, Feldstärken, Tiegelrotationsgeschwindigkeiten, Tiegelgrößen und Siliciumchargen erreicht werden. Dann können eine Tiegelrotationsgeschwindigkeit und ein Feldstärkenerhöhungsprogramm zur Erzielung der gewünschten Sauerstoffverteilung abgeleitet werden.

## Patentansprüche

1. Czochralski-Verfahren zur Herstellung von Einkristallsiliciumstäben, wobei ein Einkristallstab aus einer Siliciumschmelze gezogen wird, die sich in einem Tiegel befindet, und Einkristallsiliciumstäbe und Tiegel koaxial sind; und wobei das Verfahren die folgenden Schritte umfaβt:
- Drehen des Stabs und des Tiegels in entgegengesetzten Richtungen um ihre Achsen, wobei während des Wachstums des Stabs die Rotationsgeschwindigkeit des Stabs gröβer als die des Tiegels ist,
- Steigern der Tiegelrotationsgeschwindigkeit mit zunehmender Stablänge,
- Aufprägen eines scheitelförmig ausgebildeten Magnetfeldes auf die Siliciumschmelze, das im wesentlichen rotationssymmetrisch um die Achse des Stabs ist, bis ein Teil der Siliciumschmelze verfestigt ist, wobei das Magnetfeld Komponenten besitzt, die den Boden und die Seitenwände des Tiegels rechtwinklig durchdringen, und
- mit zunehmendem Anteil verfestigter Siliciumschmelze Vermindern der Intensität der Magnetfeldkomponente, die den Boden und die Seitenwände des Tiegels rechtwinklig durchdringt, wobei die durchschnittliche Magnetfeldkomponente, die die geschmolzene Siliciumoberfläche rechtwinklig durchdringt, klein ist in Bezug auf die den Boden und die Seitenwände des Tiegels rechtwinklig durchdringende durchschnittliche Magnetfeldkomponente.

2. Verfahren nach Anspruch 1, **dadurch gekennzeichnet,** daß Magnetfeldkomponenten, die den Boden und die Seitenwände des Tiegels rechtwinklig durchdringen, auf Null reduziert werden, nachdem der Anteil der verfestigten Siliciumschmelze 0,5 überschritten hat.

3. Verfahren nach Anspruch 2, **dadurch gekennzeichnet**, daß die Einkristallrotationsgeschwindigkeit die Tiegelrotationsgeschwindigkeit während des Wachstums des Einkristallstabs um mindestens 5 U/min übersteigt.

4. Verfahren nach Anspruch 2, **dadurch gekennzeichnet,** daß der Einkristallsiliciumstab einen Durchmesser von 200 mm hat und die Summe der Tiegel- und Kristallrotationsgeschwindigkeit 27 U/min nicht überschreitet.

5. Verfahren nach Anspruch 2, **dadurch gekennzeichnet,** daß der Einkristallsiliciumstab einen Durchmesser von 150 mm hat und die Summe der Tiegel- und Kristallrotationsgeschwindigkeiten 32 U/min nicht überschreitet.

6. Verfahren nach Anspruch 1, **dadurch gekennzeichnet,** daß die Magnetfeldkomponenten, die den Boden und die Seitenwände des Tiegels rechtwinklig durchdringen, auf Null reduziert werden, nachdem der Anteil der verfestigten Siliciumschmelze 0,8 überschritten hat.

7. Verfahren nach Anspruch 6, **dadurch gekennzeichnet,** daß die Einkristallrotationsgeschwindigkeit die Tiegelrotationsgeschwindigkeit während des Ziehens des Einkristallstabs um mindestens 5 U/min übersteigt.

8. Verfahren nach Anspruch 1, **dadurch gekennzeichnet,** daß der Durchschnitt der Magnetfeldkomponenten, die den Boden und die Seitenwände des Tiegels, die mit der Siliciumschmelze in Berührung kommen, rechtwinklig durchdringen, anfänglich mindestens 500 Gauß beträgt.

9. Verfahren nach Anspruch 8, **dadurch gekennzeichnet,** daß die Magnetfeldkomponenten, die den Boden und die Seitenwände des Tiegels, die mit der Siliciumschmelze in Berührung kommen, rechtwinklig durchdringen, auf Null reduziert werden, nachdem der Anteil der verfestigten Siliciumschmelze 0,8 überschritten hat.

10. Verfahren nach Anspruch 9, **dadurch gekennzeichnet,** daß der Einkristallsiliciumstab einen Durchmesser von mindestens 200 mm hat und die Summe der Tiegel- und Kristallrotationsgeschwindigkeiten 27 U/min nicht überschreitet.

11. Verfahren nach Anspruch 1, **dadurch gekennzeichnet,** daß der Einkristallsiliciumstab einen Durchmesser von mindestens 200 mm hat und die Summe der Tiegel- und Kristallrotationsgeschwindigkeiten 27 U/min nicht überschreitet.

12. Verfahren nach Anspruch 1, **dadurch gekennzeichnet,** daß der Einkristallsiliciumstab einen Durchmesser von mindestens 150 mm hat und die Summe der Tiegel- und Kristallrotationsgeschwindigkeiten 32 U/min nicht überschreitet.

13. Verfahren nach Anspruch 1, **dadurch gekennzeichnet,** daß die Einkristallrotationsgeschwindigkeit die Tiegelrotationsgeschwindigkeit während des Ziehens des Einkristallsiliciumstabs um mindestens 5 U/min übersteigt.

14. Verfahren nach Anspruch 1, **dadurch gekennzeichnet,** daβ der axiale Sauerstoffkonzentrationsgradient im Einkristrallsiliciumstab 5 % nicht übersteigt.

15. Verfahren nach Anspruch 1, **dadurch gekennzeichnet,** daß die durchschnittliche Magnetfeldkomponente rechtwinklig zur Siliciumschmelzenoberfläche während des Ziehens des Einkristallsiliciumstabs Null beträgt.

## Claims

1. Czochralski method for producing single crystal silicon rods, wherein a silicon rod is pulled from a silicon melt present in a crucible, the single crystal silicon rods and the crucible being coaxial, and the method comprising the following steps:
- Rotating the rod and the crucible in opposite directions about their axes, the rotation rate of the rod being greater than that of the crucible during the growth of the rod,
- Increasing the crucible rotation rate as the length of the rod increases,
- Imposing a magnetic field formed with a cusp shape and substantially rotationally symmetrical about the axis of the rod on the silicon melt until a part of the silicon melt is solidified, the magnetic field having components which perpendicularly intersect the bottom and the side walls of the crucible, while as the fraction of solidified silicon melt increases the intensity of the magnetic field component which perpendicularly intersects the bottom and the side walls of the crucible is reduced and the average magnetic field component which perpendicularly intersects the molten silicon surface is small in relation to the magnetic field component which perpendicularly intersects the bottom and the side walls of the crucible.

2. Method according to Claim 1, characterized in that the magnetic field components which perpendicularly intersect the bottom and the side walls of the crucible are reduced to zero after the fraction of solidified silicon melt has exceeded 0.5.

3. Method according to Claim 2, characterized in that the single crystal rotation rate exceeds the crucible rotation rate during the growth of the single crystal rod by at least 5 r.p.m.

4. Method according to Claim 2, characterized in that the single crystal rod has a diameter of 200mm and the sum of the crucible and crystal rotation rates does not exceed 27 r.p.m.

5. Method according to Claim 2, characterized in that the single crystal rod has a diameter of 150mm and the sum of the crucible and crystal rotation rates does not exceed 32 r.p.m.

6. Method according to Claim 1, characterized in that the magnetic field components which perpendicularly intersect the bottom and the side walls of the crucible are reduced to zero after the fraction of solidified silicon melt has exceeded 0.8.

7. Method according to Claim 6, characterized in that the single crystal rotation rate exceeds the crucible rotation rate by at least 5 r.p.m. as the single crystal rod is pulled.

8. Method according to Claim 1, characterized in that the average of those magnetic field components which perpendicularly intersect the bottom and the side walls of the crucible which come in contact with the silicon melt initially amounts to at least 500 Gauss.

9. Method according to Claim 8, characterized in that those magnetic field components which perpendicularly intersect the bottom and the side walls of the crucible which come in contact with the silicon melt are reduced to zero after the fraction of silicon melt solidified has exceeded 0.8.

10. Method according to Claim 9, characterized in that the single crystal silicon rod has a diameter of at least 200mm and that the sum of the crucible and crystal rotation rates does not exceed 27 r.p.m.

11. Method according to Claim 1, characterized in that the single crystal silicon rod has a diameter of at least 200mm and the sum of the crucible and crystal rotation rates does not exceed 27 r.p.m.

12. Method according to Claim 1, characterized in that the single crystal silicon rod has a diameter of at least 150mm and the sum of the crucible and crystal rotation rates does not exceed 32 r.p.m.

13. Method according to Claim 1, characterized in that the single crystal rotation rate exceeds the crucible rotation rate by at least 5 r.p.m. as the single crystal silicon rod is being pulled.

14. Method according to Claim 1, characterized in that the axial oxygen concentration gradient in the rod does not exceed 5%.

15. Method according to Claim 1, characterized in that the average magnetic field component perpendicular to the silicon melt surface amounts to zero as the single crystal silicon rod is pulled.

## Revendications

1. Procédé Czochralski pour produire des lingots de silicium monocristallin, dans lequel un lingot monocristallin est obtenu par tirage à partir d'une masse de silicium en fusion placée dans un creuset, le lingot de silicium monocristallin et le creuset étant disposés selon le même axe, le procédé comportant les étapes suivantes :
- mise en rotation du lingot et du creuset, en sens inverse autour de leur axe commun, la vitesse de rotation du lingot, pendant la croissance du lingot, étant supérieure à celle du creuset,
- augmentation de la vitesse de rotation du creuset au fur et à mesure de l'augmentation de la longueur du lingot,
- application à la masse de silicium en fusion d'un champ magnétique de crête stationnaire qui présente une symétrie de rotation autour de l'axe du lingot, jusqu'à ce qu'une partie de la masse de silicium en fusion soit figée, le champ magnétique ayant des composantes qui traversent perpendiculairement le fond et les parois latérales du creuset, et
- réduction, au fur et à mesure qu'augmente la partie de la masse de silicium en fusion qui se trouve figée, de l'intensité des composantes du champ magnétique qui traversent perpendiculairement le fond et les parois latérales du creuset, la composante moyenne du champ magnétique qui traverse perpendiculairement la surface du silicium en fusion étant faible comparée à la composante moyenne du champ magnétique qui traverse perpendiculairement le fond et les parois latérales du creuset.

2. Procédé selon la revendication 1, caractérisé en ce que les composantes du champ magnétique qui traversent perpendiculairement le fond et les parois latérales du creuset sont réduites à zéro après que la proportion de silicium en fusion qui s'est figée a dépassé 0,5.

3. Procédé selon la revendication 2, caractérisé en ce que la vitesse de rotation du monocristal est supérieure d'au moins 5 tr/min à la vitesse de rotation du creuset pendant la croissance du lingot monocristallin.

4. Procédé selon la revendication 2, caractérisé en ce que le lingot de silicium monocristallin a un diamètre de 200 mm et en ce que la somme des vitesses de rotation du creuset et du cristal ne dépasse pas 27 tr/min.

5. Procédé selon la revendication 2, caractérisé en ce que le lingot de silicium monocristallin a un diamètre de 150 mm et en ce que la somme des vitesses de rotation du creuset et du cristal ne dépasse pas 32 tr/min.

6. Procédé selon la revendication 1, caractérisé en ce que les composantes du champ magnétique qui traversent perpendiculairement le fond et les parois latérales du creuset sont réduites à zéro après que la proportion de silicium en fusion qui s'est figée a dépassé 0,8.

7. Procédé selon la revendication 6, caractérisé en ce que la vitesse de rotation du monocristal est supérieure d'au moins 5 tr/min à la vitesse de rotation du creuset pendant le tirage du lingot monocristallin.

8. Procédé selon la revendication 1, caractérisé en ce que la moyenne des composantes du champ magnétique qui traversent perpendiculairement le fond et les parois latérales du creuset qui entrent en contact avec la masse de silicium en fusion est, au début, d'au moins 500 gauss.

9. Procédé selon la revendication 8, caractérisé en ce que les composantes du champ magnétique qui traversent perpendiculairement le fond et les parois latérales du creuset qui entrent en contact avec la masse de silicium en fusion sont réduites à zéro après que la proportion de silicium en fusion qui s'est figée a dépassé 0,8.

10. Procédé selon la revendication 9, caractérisé en ce que le lingot de silicium monocristallin a un diamètre d'au moins 200 mm et en ce que la somme des vitesses de rotation du creuset et du cristal ne dépasse pas 27 tr/min.

11. Procédé selon la revendication 1, caractérisé en ce que le lingot de silicium monocristallin a un diamètre d'au moins 200 mm et en ce que la somme des vitesses de rotation du creuset et du cristal ne dépasse pas 27 tr/min.

12. Procédé selon la revendication 1, caractérisé en ce que le lingot de silicium monocristallin a un diamètre d'au moins 150 mm et en ce que la somme des vitesses de rotation du creuset et du cristal ne dépasse pas 32 tr/min.

13. Procédé selon la revendication 1, caractérisé en ce que la vitesse de rotation du monocristal est supérieure d'au moins 5 tr/min à la vitesse de rotation du creuset pendant le tirage du lingot de silicium monocristallin.

14. Procédé selon la revendication 1, caractérisé en ce que le gradient axial de la concentration en oxygène dans le lingot de silicium monocristallin ne dépasse pas 5 %.

15. Procédé selon la revendication 1, caractérisé en ce que la composante moyenne du champ magnétique perpendiculaire à la surface de la masse de silicium en fusion est égale à zéro pendant le tirage du lingot de silicium monocristallin.
